# EUROPEAN PATENT APPLICATION

(11) **EP 0 567 937 A2**
(43) Date of publication of application: **03.11.1993**
(21) Application number: 93106587.4
(22) Date of filing: 22.04.1993
(51) Int. Cl.: H01L 23/485, H01L 21/78

(54) **High reliability die processing**

(30) Priority: 30.04.1992 US 877967
(71) Applicant: TEXAS INSTRUMENTS INCORPORATED, Dallas Texas 75265 (US)
(72) Inventor: Whitney, Brad P., Garland, TX 75043 (US); Mach, Richard, Dallas, TX 75249 (US)
(74) Representative: Schwepfinger, Karl-Heinz, Dipl.-Ing.

(57) **Abstract**

A hermetic die includes a bond pad which extends the high temperature range capability of plastic encapsulated devices. The die preferably includes a layer of field oxide (56) grown on selected areas of a silicon wafer (50). A barrier metal layer (70) is formed to extend laterally from a first point to a second point on oxide (56). Aluminum bond pad layer (74) is formed over barrier metal layer (70). Compressive nitride layer (26) is then formed over exposed areas of field oxide (56), extending laterally interior the lateral edges of layer (70) and pad (74). A second barrier metal layer (80) comprising titanium tungsten is deposited over pad layer (74) followed by the deposition of gold bond pad layer (84).

## Description

### TECHNICAL FIELD OF THE INVENTION

The present invention relates to plastic encapsulated integrated circuit technology and, more particularly, to improvements in bonding to integrated circuits and methods of fabricating same.

### BACKGROUND OF THE INVENTION

Until now, the use of plastic encapsulated integrated circuit technology has been restricted to environments having temperatures of 125°C or less. High risk, high stress environments required chips to be sealed in expensive, large and cumbersome metal or ceramic packaging. High risk, high stress environments may be found in the petroleum, automotive and military industries, in such areas as down hole drilling, engine compartments and aircraft mount items.

In conventional integrated circuit manufacture, a semiconductor chip includes a layer of metallization, typically aluminum, for forming interconnects between devices on the chip. A gold bond wire is used to connect the aluminum bond pads of the integrated circuit to the metal of the lead frame. At temperatures over 125°C, aluminum reacts in the presence of gold to form what is commonly referred to as "purple plague". Purple plague corrosion results in the gold bond wires breaking during thermal stress. Additionally, moisture-activated reliability problems related to nitride openings in the bond pad region and chips in the surrounding field oxide cause problems of moisture and ionic contamination.

One attempt to solve purple plague has been devised wherein a gold bond wire connects to a gold bond pad formed on the upper face of the aluminum bond pad. Consequently, no purple plague forms between the bond wire attached to the gold bond pad. However, purple plague still forms between the aluminum bond pad and the gold bond pad.

A long felt need continues to exist for a high reliability die and improved processing which avoid problems of purple plaque corrosion, hermetically seals the die to avoid contamination problems and extends the high temperature range capability of plastic encapsulated devices.

### SUMMARY OF THE INVENTION

According to the invention, a hermetic die is formed on an integrated circuit workpiece. A first layer of barrier metal is formed on a selected area of the workpiece and extends laterally between two points on the selected area. An aluminum bond pad is formed over the first layer of barrier metal. A nitride passivation layer is formed over portions of the field oxide, extending to cover lateral edges of the first layer of barrier metal and aluminum bond pad layer to protect the bond. A second layer of barrier metal is formed over the aluminum bond pad layer, overlapping the nitride passivation layer. A gold bond pad layer is formed over the second layer of barrier metal. Thermal compression bonding is used to attach a gold bond wire to the gold bond pad layer in order to connect the pad to a lead frame.

The invention provides a high reliability die having many advantages. One technical advantage is the die is hermetically sealed to avoid contamination problems. Another technical advantage is that the multilayer bond pad avoids corrosion problems. Further, the plastic encapsulated integrated circuit that is provided according to the invention is more reliable and, at the same time, more economical, than the die produced for ceramic or metal packages. The invention yields higher reliability at virtually no extra cost.

### BRIEF DESCRIPTION OF THE DRAWINGS

Further aspects of the invention and their advantages will be discerned when one refers to the following detailed description as taken in conjunction with the drawings, in which:
FIGURE 1 is an enlarged schematic plan view of an integrated circuit chip or die capable of employing the present invention;
FIGURE 2 is an enlarged detail plan view of a portion of FIGURE 1, showing one bonding pad employing the present invention;
FIGURE 3 is a highly magnified schematic elevational sectional view taken substantially along line III-III of FIGURE 2; and
FIGURE 4 is a highly magnified schematic elevational sectional view taken substantially along line IV-IV of FIGURE 2.

### DETAILED DESCRIPTION OF THE INVENTION

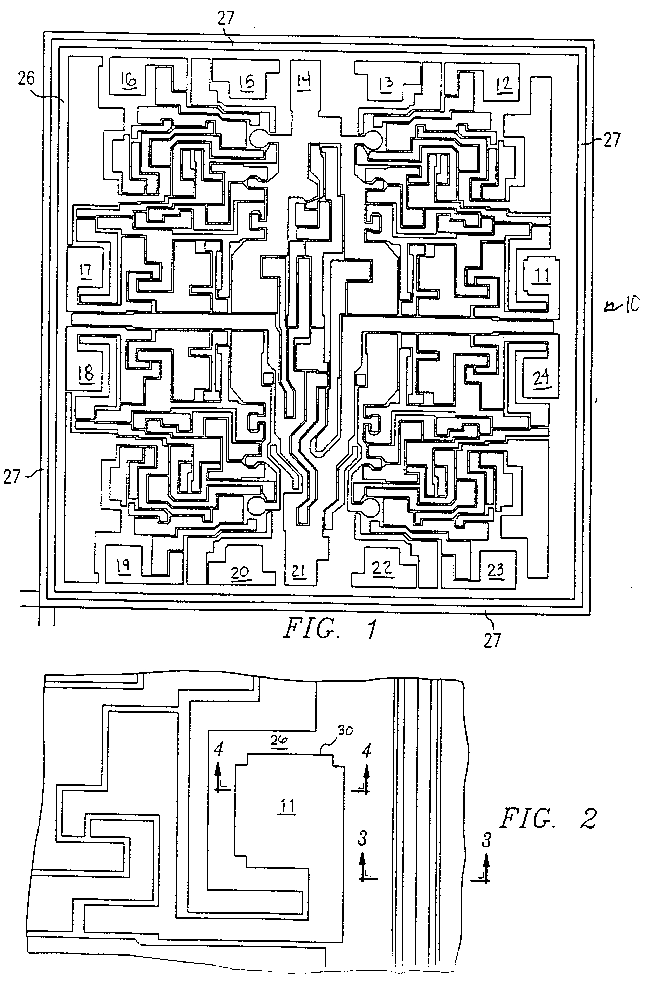

The preferred embodiment of the present invention and its advantages are best understood by referring to FIGUREs 1 through 4 of the drawings, like numerals being used for like and corresponding parts of the various drawings.

FIGURE 1 is a semiconductor chip shown generally at 10. Semiconductor chip 10 includes bond pads 11 through 24. Nitride passivation layers for die 10 and an adjacent die (otherwise not shown) are shown at 26. Nitride is not present on scribe streets 27, which bound the borders of die 10 and separate die 10 from adjoining dies.

FIGURE 2 is a highly magnified detail showing a portion of FIGURE 1, in which a bond pad according to the invention is shown generally at 30. Gold wire (not shown) will attach to gold bond pad area 11. A compressive nitride passivation layer 26 surrounds the bond pad. The compressive nitride is approximately 10,000Å in thickness and is resistant to cracks and folds during processing. The shape of the bond pad shown is square, but may be (e.g.) round, hexagonal or octagonal in shape without affecting its reliability.

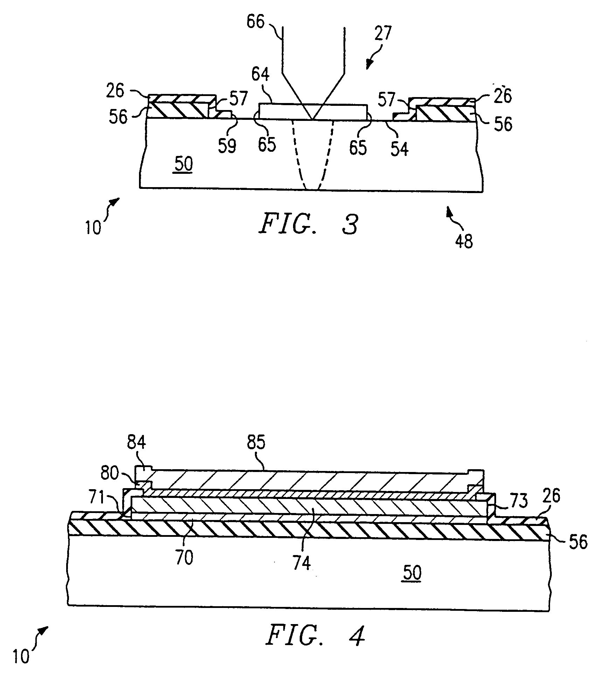

FIGURE 3 is a highly magnified elevational sectional view, taken substantially along line III-III of FIGURE 2, of a portion of die 10 and an adjacent die 48 depicting the scribe street area 27. A semiconductor substrate 50 has an upper surface 54. The substrate includes at least one semiconductor device, such as a transistor or an array of memory cells. Field oxide 56, formed to a thickness is approximately 8,000Å, is grown in selected regions on the face 54 of substrate 50. Nitride passivation layer 26 is formed on field oxide 56 to a thickness of approximately 10,000Å. Additionally, nitride passivation layer 26 is patterned and etched to extend approximately 0.2 millimeters from edge 57 of field oxide layer 56. The scribe street 27 has no nitride passivation layer on it. Nitride passivation is a common barrier formed on the top surface of an integrated circuit, which acts as a physical barrier to moisture, protects the circuit from scratches and mechanical defects and helps protect the circuit from ionic contamination.

Slice alignment marker (SLAM) area 64 defines an area through which scribe street 27 is cut. SLAM area 64 consists of various geometries of oxide, nitride and other elements on each individual mask level, which allow proper alignment of each progressive mask level in the processing of a die. The alignment marker for each level is made over scribe street area 27. A saw 66 is used to cut through SLAM 64 and scribe street area 27. Upon completion of the saw operation, an object (not shown) is dragged across the scribe street to break each pad apart at the sawing incision shown in dotted line.

The saw operation may cause cracks in the silicon substrate 50. These cracks may develop into significant channels for contamination. Additionally, the conventional bond pad assignments have moisture-related reliability problems due to nitride openings in the bond pad region. If the saw cuts too wide, its kerf cuts into the nitride passivation layer. Consequently, moisture or ionic contamination may result.

The present invention shown in FIGURE 3 solves the problems caused during the sawing operation. A lateral distance of 0.2 millimeters is required between edge 57 of layer 56 and edge 59 of layer 26. Further, the present invention employs a narrow saw blade running at speeds fast enough to clearly cut scribe street area 27 with no cracks or chips into the nitride layer 26. Another 0.2 millimeters exists between the lateral edges 65 of SLAM 64 and the edge 59 of the nitride 26, so that no cracks get into the nitride 26. The die remains hermetically sealed when there are no cracks or chips into the cap nitride.

FIGURE 4 is a highly magnified schematic cross-sectional view taken substantially along line IV-IV of FIGURE 2. The field oxide 56 is grown to a thickness of approximately 8,000-10,000Å on the face 54 of the substrate 50. Field oxide 56 is then patterned and etched to form electrical contacts (not shown) elsewhere in the integrated circuit.

Next, a first barrier metal layer 70, such as may be formed of titanium tungsten alloy or, alternatively, a thin layer of platinum followed by titanium tungsten alloy, is deposited to a thickness of approximately 2,000Å, on a selected region of the field oxide layer 56. Aluminum bond pad layer 74 is then deposited over layer 70 to a thickness of approximately, but not limited to, 80 micro inches (about 20,000 Å). Sputtered or evaporated aluminum may be successfully used for bond pad layer 74. Bond pad 74 and barrier metal 70 are then patterned and wet or dry etched to extend laterally from a first point 71 to a second point 73. Note that the bond pad could also be formed directly on a silicone or other semiconductor surface without a field oxide layer. Next, according to the invention, a compressive nitride passivation layer 26 is deposited to a thickness of approximately 10,000Å. Nitride layer 26 is then patterned and etched to open the bond pad areas and scribe street areas (see FIGURE 3). In the illustrated embodiment, aluminum bond pad layer 74 should be exposed over an area having a lateral dimension of at least four millimeters. The scribe street area is left open to provide a nitride free area for the saw operation (discussed *supra*) to occur. This compressive nitride passivation layer 26 laterally overlaps layers 70 and 74 by approximately 0.2 millimeters. Up to this point, the formation of layers 70 and 74 is conventional and may be done by any standard metallization process. Some of the applicable metal systems include, but are not limited to systems comprising:
(a) Al-Si(1%) having a thickness of 40 micro-inches, formed using a wet/dry etch process on a wafer size of 100mm;
(b) Al-Si(1%)-Cu(0.5%) having a thickness of 80 micro-inches, formed using a dry etch process on a wafer size of 150mm;
(c) Al-Si(1%)-Cu(0.5%) having a thickness of 80 micro-inches, formed using a wet etch process on a wafer size of 100mm; and
(d) Al/Cu(0.25%) having a thickness of 80 micro-inches, formed using a wet etch process on a wafer size of 100mm.

Conventional bond pads have problems due to bond failure created by the chemical reaction at the interface between gold and aluminum. The bond failure is due to the inherent crystallographic mismatch that occurs as gold diffuses into the aluminum. The present invention solves these problems by adding a barrier metal to cap an aluminum bond pad which already has been processed through the compressive nitride step.

According to the invention, the second barrier metal layer 80 is deposited to a thickness of approximately 3,000Å. This layer 80 may consist of titanium tungsten alloy or other refractory metal. Next, a gold bond pad layer 84 is deposited to a depth of approximately 1,000Å. Layer 80 and pad 84 may be deposited by vapor deposition, evaporation, sputtering or chemical plating. These layers 80 and 84 do not have to be formed in a wafer fab environment, as they are not as sensitive to changes in the environment. The second layer of barrier metal 80 and the gold bond pad layer 84 should overlap the nitride passivation layer. The overlap helps to ensure that no moisture seeps into the silicon layer 50. The extent of the overlap is a function of the actual process used in forming the second layer of barrier metal and the gold bond. It may, for example, measure approximately 0.5 millimeters.

Finally, according to the invention, a gold bond wire with a terminal ball (not shown) is bonded to the top surface 85 of gold bond pad 84. The bond wire should be sited squarely on the bond pad surface 85 and should not touch the nitride layer 26. Accordingly, the bond pad 84 should be big enough to keep the wire inside the bond pad area. Otherwise, the bonding pressure will crack the nitride layer 26 and allow moisture contamination.

Conventional bond pads include a silicon wafer or chip, a layer of field oxide, a metal bond pad layer and the nitride passivation layer to prevent contamination. When the bond wire is attached to the bond pad layer, a stress fracture or crack often forms. Over time, the crack may cause a short to develop between the bond pad and silicon wafer. At that point, with a little stress the bond wire and pad layer come out leaving a big hole in the wafer. This hole is called "chip out." The solution to chip out, as particularly pointed out by the present invention, includes depositing a first barrier metal layer underneath the aluminum bond pad.

According to the invention, no purple plague corrosion occurs, even under high temperatures, because the barrier metals insulate the gold, aluminum and silicon from each other.

In practicing the process of the present invention, using the bond pad described in FIGURE 4, reliability issues involving contaminant penetration into the die was reduced by several orders of magnitude due to the improved process which effectively hermetically sealed the die. First, the nitride cap prevents any penetration into the die via the edge of the die from the saw operation. Second, the gold cap prevents any nitride opening in the bond pad. Additionally, extended temperature range operation (above 138° C) was possible due to the elimination of any purple plague corrosion problem at the bond pad/ball bond interface. Consequently, products can now be offered at 150° C, whereas in the past, products for use in temperatures above 125° C were not offered.

The process of the invention is feasible for various metal options and is not limited to any particular device types. Some of the applicable metal systems include, but are not limited to systems comprising:
(e) Al-Si(1%) having a thickness of 40 micro-inches, formed using a wet/dry etch process on a wafer size of 100mm;
(f) Al-Si(1%)-Cu(0.5%) having a thickness of 80 micro-inches, formed using a dry etch process on a wafer size of 150mm;
(g) Al-Si(1%)-Cu(0.5%) having a thickness of 80 micro-inches, formed using a wet etch process on a wafer size of 100mm; and
(h) Al/Cu(0.25%) having a thickness of 80 micro-inches, formed using a wet etch process on a wafer size of 100mm.

Although the present invention and its advantages have been described in detail, it should be understood that various changes, substitutions and alterations can be made herein without departing from the spirit and scope of the invention as defined by the appended claims.

Additionally, the invention is valid for processes including, but not limited to, bipolar, 4/3 CMOS, LinEpic, bipolar complementary, bifet and CMOS. The invention also is valid with varying degrees of design shrinks.

## Claims

1. A hermetic die, comprising:
a silicon workpiece;
a metal bond pad formed on a selected area of said workpiece;
a first layer of barrier metal formed on an upper face of said metal bond pad; and
a gold bond pad formed on an upper face of said barrier metal layer.

2. The hermetic die of claim 1 further comprising:
a field oxide layer formed on a face of the silicon workpiece;
a second layer of barrier metal formed on a selected area of said field oxide and wherein the metal bond pad is an aluminum bond pad formed on an upper face of said second layer of barrier metal;
a first layer of barrier metal formed on an upper face of said aluminum bond pad; and
a gold bond pad formed on an upper face of said second layer of barrier metal.

3. The hermetic die of claim 1 or claim 2, wherein the or each barrier metal comprises a titanium tungsten alloy.

4. An integrated circuit chip, comprising;
a semiconductor substrate having formed therein at least one semiconductor device and including a surface;
an insulator layer formed on said surface and having a face opposed to said surface, a plurality of contact areas formed from said face through said insulator layer to said surface;
a first barrier metal layer formed in said contact areas and on said face;
an aluminum layer formed on said first barrier metal layer and having a surface remote from said first barrier metal layer, said first barrier metal layer and said aluminum layer selectively removed to form a metallization layer having lateral edges, said metallization layer including at least one bond pad area;
a passivation layer formed over said integrated circuit chip to cover lateral edges of said metallization layer, and leaving an opening within said bond pad area;
a second barrier metal layer formed to cover said surface of said aluminum layer within said bond pad area; and
a gold layer formed on said second barrier metal layer within said bond pad area.

5. An integrated circuit semiconductor workpiece, comprising:
a semiconductor substrate having a surface, at least two dies of said semiconductor substrate separated by a scribe street;
each of said dies having a lateral margin forming a border of said scribe street, an insulator layer formed on said surface within each said die up to said lateral margins;
a passivation layer formed on said insulator layer to cover said lateral margins of said insulator layer, said passivation layer having lateral margins extending into said scribe street, a lateral space between opposed ones of said lateral margins of said passivation layer defined to be sufficiently large to allow the separation of said dies without cracks running beyond said lateral margins of said passivation layer.

6. The workpiece of claim 5, wherein a slice alignment marker (SLAM) is formed on the surface of the semiconductor workpiece between said lateral margins of the passivation layer.

7. The work piece of claim 5 or claim 6, further comprising:
an insulator layer formed on said surface and having a face opposed to said surface, a plurality of contact areas formed from said face through said insulator layer to said surface;
a first barrier metal layer formed in said contact areas and on said face;
an aluminum layer formed on said first barrier metal layer and having a surface remote from said first barrier metal layer, said first barrier metal layer and said aluminum layer selectively removed to form a metallization layer having lateral edges, said metallization layer including at least one bond pad area;
a passivation layer formed over said integrated circuit chip to cover lateral edges of said metallization layer; and leaving an opening within said bond pad area;
a second barrier metal layer formed to cover said surface of said aluminum layer within said bond pad area; and
a gold layer formed on said second barrier metal layer within said bond pad area.

8. A process for fabricating a bond pad at a face of an integrated circuit semiconductor workpiece, comprising the steps of:
forming an insulating layer on said face;
forming a first layer of barrier metal having lateral edges on a selected region of the insulating layer;
forming an aluminum bond pad layer having lateral edges on the first layer of barrier metal;
forming a dielectric passivation layer to cover the lateral edges of the first layer of barrier metal and aluminum bond pad layer within the region;
forming a second layer of barrier metal on an upper face of said aluminum bond pad layer; and
forming a gold bond pad layer on the second layer of barrier metal.

9. The process of claim 8, wherein said dielectric passivation layer comprises nitride.

10. The process of claim 8 or claim 9, wherein said dielectric passivation layer is deposited to a thickness of not less than about 10,000Å.

11. The process of any of claims 8 to 10, wherein said aluminum bond pad layer is deposited to a thickness of not less than about 80 micro inches.

12. The process of any of claims 8 to 11, wherein said lateral edges of said passivation layer are laterally interior of said lateral edges of said aluminum bond pad layer and said first layer of barrier metal.

13. The process of claim 12, wherein said lateral edges of said passivation layer are laterally interior of the lateral edges of said aluminum bond pad layer and said layer of barrier metal by not less than 0.2 millimeters.

14. The process of any of claims 8 to 13, wherein lateral edges of said second barrier metal and said gold bond pad layer overlap said dielectric passivation layer.

15. The process of any of claims 8 to 14, wherein said first layer of barrier metal is deposited to a thickness of not less than 2,000Å.

16. The process of any of claims 8 to 15, wherein the barrier metal comprises titanium tungsten alloy.

17. The process of claim 16, wherein said first layer of barrier metal further comprises a thin layer of platinum followed the titanium tungsten alloy.

18. The process of any of claims 8 to 17, wherein said gold bond pad layer is deposited to a thickness of not less than 1,000Å.

19. The process of any of claims 8 to 18, wherein lateral edges of said second layer of barrier metal and gold bond pad layer are laterally exterior to said lateral edges of said passivation layer.
